Europäisches Patentamt

European Patent Office

Office européen des brevets

(11) Numéro de publication: **0 044 280**

**B1**

(12) **FASCICULE DE BREVET EUROPEEN**

(45) Date de publication du fascicule du brevet: **18.12.85**

(21) Numéro de dépôt: **81810286.5**

(22) Date de dépôt: **14.07.81**

(51) Int. Cl.⁴: **G 03 B 27/62**, G 03 C 5/08, G 03 F 1/04

(54) Cache pour la génération de documents, procédé pour sa fabrication et moyens de mise en oeuvre.

(30) Priorité: **14.07.80 CH 5385/80**

(43) Date de publication de la demande:
**20.01.82 Bulletin 82/03**

(45) Mention de la délivrance du brevet:
**18.12.85 Bulletin 85/51**

(84) Etats contractants désignés:
**AT BE DE FR GB IT NL SE**

(56) Documents cités:
DE-B-1 099 844
DE-B-1 597 698
FR-A- 978 614
FR-A-2 098 540
FR-A-2 188 850
FR-A-2 388 299
FR-A-2 454 915
GB-A-1 118 004
US-A-2 020 821
US-A-2 487 494
US-A-2 654 289
US-A-3 353 281
US-A-3 767 752

(73) Titulaire: **ITF Trade Facilitation S.A.**
**1, rue Caroline 1**
**CH-1003 Lausanne (CH)**

(72) Inventeur: **Zahno, Michel**
**Avenue de Valmont 16**
**CH-1010 Lausanne (CH)**

(74) Mandataire: **Hranitzky, Wilhelm Max et al**
**c/o WILLIAM BLANC & CIE Conseils en propriété**
**industrielle SA 6, rue de la Grotte**
**CH-1003 Lausanne (CH)**

㉒ Documents cités
**US-A-3 913 118**
**US-A-3 930 724**
**US-A-4 078 862**

**XEROX DISCLOSURE JOURNAL**, volume 1, no.
3, mars 1976 STAMFORD N. DAN CHANK Jr.
"Document carrier for use in friction retardtype sheet separators", page 103

**RESEARCH DISCLOSURE**, no. 191, mars 1980,
HAVANT (GB) F.A. POMEROY et al. "Document
carrier", page 87, no. 19129

Courier Press, Leamington Spa, England.

EP 0 044 280 B1

## Description

La présente invention a trait à un cache pour la reproduction de documents.

Depuis la vulgarisation des machines à photocopier, il est connu d'utiliser des caches ou marques permettant de transformer un document en le complétant ou en retranchant une partie. Ces caches sont habituellement constitués d'une feuille de matériau transparent portant la mention que l'on désire voir apparaître sur le document photocopié, par exemple "reçu" ou "rappel", etc. Ce cache, posé sur le document à photocopier permet l'obtention d'un autre document portant, en plus, l'inscription désirée.

Dans leur forme la plus ancienne, ces caches sont composés de deux parties distinctes: la partie de travail est une feuille d'acétate ou de PVC constituant le cache proprement dit et la partie de soutien est un support en papier, carton ou autre matériau rigide. Ces deux parties sont reliées entre elles par des moyens usuels, collage, bande autocollante. Dans la forme ainsi obtenue, le document à insérer vient buter contre la jonction entre les deux parties.

Dans des brevets récents, par exemple dans le brevet US 3,353,281, on décrit un cache dans lequel les documents sont disposés de façon à obtenir un alignement aussi exact que possible; un tel cache comporte une feuille dorsale sur laquelle est collée une bande d'alignement, cette bande étant munie d'encoches servant à l'alignement des documents. Dans ce cas, les documents doivent eux-mêmes être munis d'encoches correspondantes à celles de la bande d'alignement. Une autre manière d'obtenir un positionnement aussi exact que possible est celui de former une poche: une telle exécution est présentée dans le brevet US 3,913,118.

La principale difficulté à résoudre est celle de l'alignement. En effet, il est exigé par des normes recommandées par les organisations internationales, notamment par le commerce international, que les documents présentent un alignement précis. On a donc essayé d'obtenir cet alignement en améliorant sans cesse les caches existants.

Les brevets US 2,487,494 et US 3,767,752 concernent des procédés pour l'obtention de caches formés d'une seule feuille par pliage à chaud de cette feuille de façon à obtenir un bourrelet symétrique à l'endroit du pliage. Il découle de l'existence de ce bourrelet qu'une force s'exerce à cause de l'élasticité naturelle du matériau entre la partie supérieure et la partie inférieure du cache, mais sans que cette force permette un alignement précis des documents. De plus, la symétrie du bourrelet est un gros inconvénient pour l'utilisation de tels caches comme support d'un document à reproduire.

Un des buts de la présente invention est donc de présenter un cache pour la reproduction de documents satisfaisant parfaitement aux exigences d'alignement.

Pour ce faire, le cache de l'invention est composé d'une seule feuille de matériau pliée de façon à former une partie inférieure de soutien et une partie supérieure de travail et comporte un bourrelet à l'endroit du pliage; ce cache est caractérisé en ce que la partie supérieure est plane et la courbure du bourrelet telle, qu'à la fin de la zone de courbure, la partie inférieure produit une zone linéaire de pinçage.

Une telle invention comporte des avantages par rapport aux caches de l'art antérieur. En effet, d'une part, il est formé d'une seule feuille pliée: les caches formés de deux parties collées ou soudées entre elles entraînent, par un usage répété, une détérioration de la partie de liaison et par conséquent des défauts dans l'alignement. D'autre part, le cache de l'invention comporte un double moyen d'alignement: les documents sont alignés en butant contre le bourrelet à l'endroit du pliage et ils sont maintenus dans cette position par pinçage. Ce double maintien évite les dispositifs d'alignement sur les documents eux-mêmes, comme par exemple les encoches décrites dans le brevet US 3,353,281.

En vue de faciliter l'insertion des documents dans le cache, on peut prévoir que la partie supérieure de travail est plus longue que la partie de soutien. Les rebords des zones opaques peuvent être affinés en dégradé afin d'éviter sur les tirages la production de traits noirs et d'ombres. La partie de soutien peut être revêtue sur sa face interne d'une couche antistatique, afin que le document inséré ne colle pas à la paroi.

Cette invention concerne également un procédé pour la fabrication d'un tel cache, dans lequel on plie la feuille au moyen d'une lame chauffante, on presse les deux parties contre la lame chauffante, on retire la lame chauffante, on presse les parties l'une contre l'autre. Ce procédé est caractérisé en ce que les deux parties du cache sont formées par pression de deux presse-flanc, l'un des presse-flanc ayant une forme plane et l'autre une forme à décrochement angulaire, de façon à former sur l'une des parties une zone linéaire de pinçage.

Ce procédé permet de former tout d'abord un bourrelet lors du pliage et ensuite une ligne de pinçage en pressant les deux parties l'une contre l'autre. Après pressage, les deux parties, vu leur élasticité, s'écartent légèrement, en gardant toutefois un contact entre elles le long de la ligne de pinçage.

Cette invention concerne également un dispositif pour la mise en oeuvre du procédé: ce dispositif est caractérisé en ce qu'il comporte un couteau mobile à lame chauffante, un tablier fixe muni d'une gorge à butée coulissante, des presse-flancs, l'un des presse-flancs comportant un décrochement angulaire destiné à former une ligne de pinçage.

On comprendra mieux l'invention à l'aide de la description, faite à titre d'exemple et qui renvoie aux dessins ci-joints, sur lesquels:

la fig. 1 montre une vue en perspective d'un cache entrouvert dans lequel un document est partiellement introduit,

la fig. 2 montre une vue en coupe du cache, et

la fig. 3 montre un schéma d'une machine à plier.

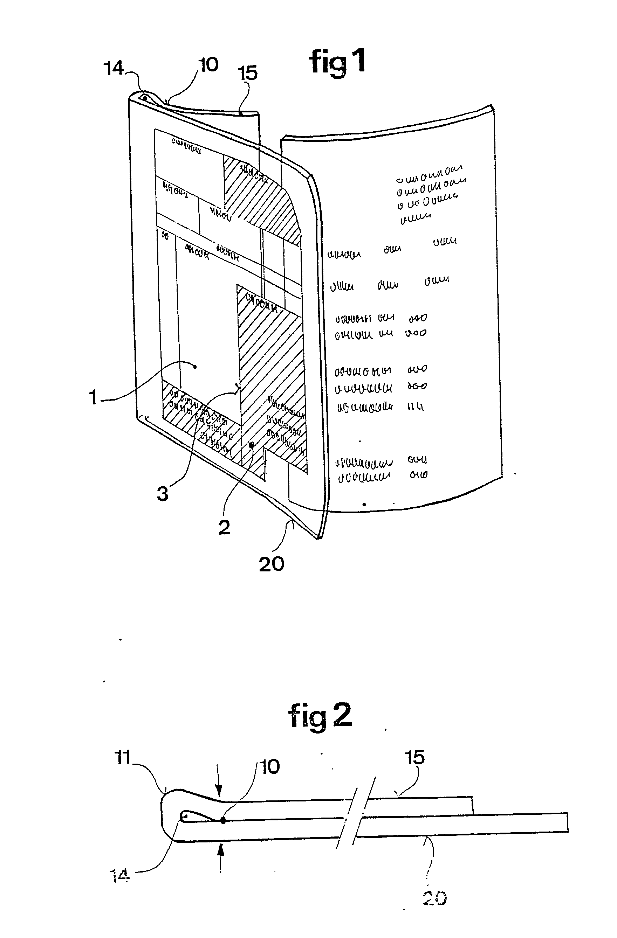

Le cache est constitué sur l'une de ses faces, dite de travail, de zones transparentes 1 (fig. 1) et de zones opaques 2, ces dernières étant réalisées en encre inactinique. Les rebords 3 de ces zones opaques sont affinés en dégradé afin de ne pas faire apparaître de traits ou traces noirs sur la photocopie. Ces dégradés peuvent être obtenus par des moyens connus en imprimerie, comme une trame mécanique elle-même dégradée, ou un flou en reproduction off-set.

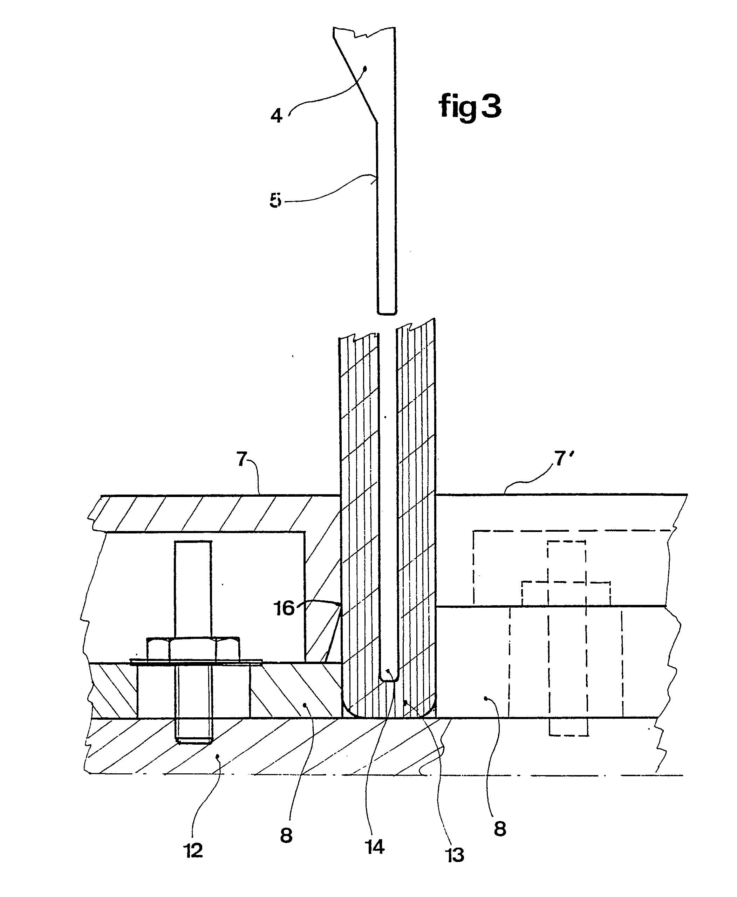

Le cache est obtenu par pliage d'une feuille d'acétate ou de PVC. Ce pliage est obtenu par une plieuse telle que celle présentée à la fig. 3. Cette plieuse comporte un couteau mobile 4 à lame chauffante 5. L'épaisseur de la lame détermine l'épaisseur du pli 14. L'épaisseur du bourrelet 11 dépend de la largeur de la gorge 13; cette largeur est réglable par glissement latéral sur le tablier 12 de la plieuse. Il est important de pouvoir régler cette largeur en vue d'obtenir des caches différents: en effet, la taille du bourrelet 11 est fonction de l'épaisseur du document que l'on veut maintenir pincé dans le cache. Pendant le pliage proprement dit au moyen de la lame chauffante 5, les deux parties sont maintenues en les pressant légèrement contre la lame au moyen des presse-flancs 7, 7'. La force avec laquelle ce pressage se fait n'interdit pas le retrait de la lame chauffante 5; dès que celle-ci est retirée, les deux parties sont pressées l'une contre l'autre en vue de former la ligne de pinçage 10. Ces opérations sont réalisées simultanément, c'est-à-dire que, lorsque la lame chauffante est en position basse, les presse-flancs s'approchent, la lame chauffante se retire et les presse-flancs continuent leur course sans arrêt.

La réalisation de la ligne de pinçage 10 se fait ici au moyen d'un décrochement angulaire 16. Dès que ces opérations sont réalisées, vu l'élasticité du matériau utilisé, la partie 15 se retire légèrement et elle forme ainsi un passage pour les documents.

De bons résultats ont été obtenus avec une lame de plieuse chauffant à 220°C pour plier des feuilles de PVC de 0,20 mm. A une telle température, l'encre imprimant le cache n'est pas altérée.

## Revendications

1. Cache pour la reproduction de documents, composé d'une seule feuille de matériau pliée de façon à former une partie inférieure de soutien (15) et une partie supérieure de travail (20) et comportant un bourrelet (11) à l'endroit du pliage, caractérisé en ce que la partie supérieure (20) est plane et la courbure du bourrelet est telle, qu'à la fin de la zone de courbure, la partie inférieure produit une zone linéaire de pinçage.

2. Cache selon la revendication 1, caractérisé en ce que la partie supérieure de travail (20) est plus longue que la partie inférieure de soutien (15).

3. Cache selon l'une des revendications 1 ou 2, caractérisé en ce que la partie supérieure de travail (20) comporte des zones opaques (2).

4. Cache selon la revendication 3, caractérisé en ce que les rebords des zones opaques (2) sont affinés en dégradé.

5. Cache selon l'une des revendications 3 ou 4, caractérisé en ce que les zones opaques (2) sont réalisées en encre inactinique.

6. Cache selon l'une des revendications 1 à 5, caractérisé en ce que la partie de soutient (15) est revêtue d'une couche antistatique sur sa face interne.

7. Procédé pour la fabrication d'un cache, selon l'une des revendications 1 à 6, dans lequel on plie la feuille au moyen d'une lame chauffante (5), on presse légèrement les parties contre la lame chauffante, on retire la lame chauffante, on presse les deux parties l'une contre l'autre, caractérisé en ce que les deux parties du cache sont formées par pression de deux presse-flanc, l'un des presse-flanc ayant une forme plane et l'autre une forme à décrochement angulaire, de façon à former sur l'une des parties une zone linéaire de pinçage.

8. Dispositif pour la mise en oeuvre du procédé selon la revendication 7, caractérisé en ce qu'il comporte un couteau mobile (4) à lame chauffante (5), un tablier fixe (12) muni d'une gorge (13) à butée coulissante (8), des presse-flancs (7, 7'), l'un des presse-flancs comportant un décrochement angulaire (16) destiné à former la ligne de pinçage (10).

## Patentansprüche

1. Maske zur Reproduktion von Documenten, bestehend aus einem einzelnen Werkstoff-Blatt, das so zusammengebogen ist, dass es ein unteres Stützteil (15) und ein oberes Arbeitsteil (20) bildet, und das an der Biegestelle einen Wulst (11) aufweist, dadurch gekennzeichnet, dass der obere Teil (20) eben ist und die Krümmung des Wulstes derart ist, dass am Ende der Krümmungszone der untere Teil eine gerade Klemmzone bildet.

2. Maske nach Patentanspruch 1, dadurch gekennzeichnet, dass der obere Arbeitsteil (20) länger ist als der untere Stützteil (15).

3. Maske nach einem der Patentansprüche 1 oder 2, dadurch gekennzeichnet, dass der obere Arbeitsteil (20) lichtundurchlässige Zonen (2) aufweist.

4. Maske nach Patentanspruch 3, dadurch gekennzeichnet, dass die Ränder der lichtundurchlässigen Zonen (2) verlaufend gebildet sind.

5. Maske nach einem der Patentansprüche 3 oder 4, dadurch gekennzeichnet, dass die lichtundurchlässigen Zonen (2) in nicht aktinischer Tinte ausgeführt sind.

6. Maske nach einem der Patentansprüche 1 bis 5, dadurch gekennzeichnet, dass der Stützteil (15) aufseiner Innenseite mit einer antistatischen Schicht überzogen ist.

7. Verfahren zur Herstellung einer Maske gemäss einem der Patentansprüche 1 bis 6, wonach man das Blatt mit Hilfe einer Heizklinge (5) biegt, die Teile leicht gegen die Heizklinge andrückt, die Heizklinge zurückzieht, die beiden Teile gegeneinander presst, dadurch gekennzeichnet, dass die beiden Teile der Maske durch den von zwei Flankenpressorganen ausgeübten Druck geformt werden, wobei eines der Flankenpressorgane eine ebene Form besitzt und das andere eine winkelförmige Abschrägung besitzt, derart, dass auf einem der Teile eine geradlinige Klemmzone gebildet wird.

8. Vorrichtung zum Durchführen des Verfahrens gemäss dem Patentanspruch 7, dadurch gekennzeichnet, dass sie ein bewegliches Messer (4) mit Heizklinge (5), eine feststehende Auflageplatte (12) mit einer einen verschiebbaren Anschlag (8) aufweisenden Hohlkehle (13), Flankenpressorgane (7, 7') aufweist, wobei eines der Flankenpressorgane eine winkelförmige Abschrägung (16) besitzt, die zur Bildung der Klemmlinie (10) dient.

## Claims

1. A mask for copying documents, made from a single sheet of material folded in such a manner as to form a lower backing surface (15) and an upper, overlay, surface (20), the fold forming a spring hinge (11), characterized by the fact that the upper surface (20) is flat and the fold such that, as the material curves back upon itself, a linear gripper strip is formed between the upper and lower surfaces.

2. A mask as claimed in Claim 1, characterized by the fact that the upper, overlay, surface (20) is longer than the lower, backing surface (15).

3. A mask as claimed in Claims 1 or 2, characterized by the fact that the upper, overlay, surface (20) comprises opaque areas (2).

4. A mask as claimed in Claim 3, characterized by the fact that the edges of the opaque areas are vignetted.

5. A mask claimed in Claims 3 or 4, characterized by the fact that the opaque areas are obtained by the use of non-actinic ink.

6. A mask as claimed in any Claims 1 through 5, characterized by the fact that the lower backing surface (15) is treated against static on its inner side.

7. A process for manufacturing a mask as claimed in any one of Claims 1 through 6, in which the sheet is folded by means of a heater blade (5), the two surfaces are pressed against the heater blade, the heater blade is withdrawn and the two surfaces are pressed together, characterized by the fact that the two surfaces of the mask are formed by the pressure of two fold-forming jaws, one of the said jaws being flat-surfaced and the other having an angular recess, so that a linear gripper strip is formed down one of the surfaces.

8. A device for carrying out the process of Claim 7, characterized by the fact that it comprises a moveable knife (4) with a heater blade (5), a fixed base (12) provided with a groove (13) having an adjustable endstop (8), fold-forming jaws (7 and 7'), one of the said jaws comprising an angular recess (16) that serves to form the gripper strip (10).

fig 1

fig 2

fig 3